# EUROPEAN PATENT SPECIFICATION

(11) **EP 2 715 800 B1**
(45) Date of publication and mention of the grant of the patent: **06.12.2017**
(21) Application number: 12793838.9
(22) Date of filing: 30.05.2012
(51) Int. Cl.: F24J 2/04

(54) **PHOTOVOLTAIC PANEL FOR POWER PANEL**
PHOTOVOLTAIKTAFEL FÜR EINE STROMTAFEL
PANNEAU PHOTOVOLTAÏQUE POUR PANNEAU D'ALIMENTATION

(30) Priority: 31.05.2011 US 201113149153
(43) Date of publication of application: 09.04.2014
(73) Proprietor: Power Panel, Inc., Oxford, MI 48371 (US)
(72) Inventor: SCHULTZ, Garth J., Oxford, Michigan 48371 (US)
(74) Representative: Schaumburg und Partner Patentanwälte mbB
(86) International application number: PCT/US2012/039974
(87) International publication number: WO 2012/166786

(56) References cited:
- WO-A1-2007/129985
- WO-A2-2009/046352
- WO-A2-2011/024084
- DE-A1- 10 322 048
- JP-A- H06 244 445
- JP-A- H09 144 257
- JP-A- 2002 039 631
- JP-A- 2005 019 655
- JP-A- 2009 016 475
- JP-A- 2009 111 034
- US-A- 5 522 944
- IBRAHIM A ET AL: "Recent advances in flat plate photovoltaic/thermal (PV/T) solar collectors", RENEWABLE AND SUSTAINABLE ENERGY REVIEWS, ELSEVIERS SCIENCE, NEW YORK, NY, US, vol. 15, no. 1, 1 January 2011 (2011-01-01), pages 352-365, XP027480767, ISSN: 1364-0321, DOI: 10.1016/J.RSER.2010.09.024 [retrieved on 2010-09-25]
- DA SILVA R M ET AL: "Hybrid photovoltaic/thermal (PV/T) solar systems simulation with Simulink/Matlab", SOLAR ENERGY, PERGAMON PRESS. OXFORD, GB, vol. 84, no. 12, 1 December 2010 (2010-12-01), pages 1985-1996, XP027493757, ISSN: 0038-092X, DOI: 10.1016/J.SOLENER.2010.10.004 [retrieved on 2010-11-01]

## Description

### FIELD

The present disclosure relates to solar panels for capturing the energy of the sunlight for heat, electricity, and air conditioning. More particularly, the present technology relates to a solar panel which can function individually or be linked together to create a source of thermal and electrical energy.

### BACKGROUND

The statements in this section merely provide background information related to the present disclosure and may not constitute prior art.

Each day, the sun provides 10,000 times the amount of energy utilized by the human race. In a single day, it provides more energy than our current population would consume in 27 years. In North America alone, it is believed that close to two trillion dollars are spent annually on energy, much of which is designated towards non-renewable, carbon-based sources, such as oil, coal, and other fossil fuels. When energy consumption for the average U.S. household is approximately 65-80% thermal and approximately 20-35% electrical, it makes sense to derive a means of satisfying both of these requirements through renewable sources.

There have been many advances in the past few decades toward the capture of renewable energy resources, such as water turbines (which convert the kinetic energy of moving water into electricity), wind generators (which convert the energy of the wind into electrical energy), geothermal heating (which utilizes the stability of the subterraneous temperature to provide thermal energy), and solar cells (which allow the capture and conversion of solar energy into electrical energy).

Solar panels are manufactured by joining individual solar cells to form a strip or series of individual cells which are mounted in a tray having a substantially flat mounting surface. The cells are adhered to the tray and are surrounded or encapsulated within a transparent material in such a manner that light entering the solar panel will pass substantially unobstructed through the transparent encapsulant for the cells and will impinge upon exposed surfaces of the individual solar energy cells. Typically, a solar panel is formed from at least one solar energy cell in the form of a thin 3-inch diameter wafer that has one of its two planar surfaces adhered to the flat base of the tray that comprises the base element of the solar panel and the other planar surface of the cell directed toward the open top of the tray and in position to receive light impinging thereupon. The transparent material is usually selected from those that will not only provide minimal obstruction to the passage of light through the encapsulating material to the exposed planar surface of the cell, but which will also have optimal weathering characteristics to protect the encapsulated cells from ambient conditions. An example of this can be found in U.S. Patent No. 4,057,439, issued to Lindmayer.

An alternative type of renewable energy is a solar thermal heat exchanger, which utilizes the energy of sunlight to heat a liquid, thereby providing thermal energy for heating or cooling. In this type of energy harnessing, typically a flat plate is blackened on the front to improve absorption of solar radiation and is arranged with its blackened surface facing the sun and sloped at a suitable angle to optimize the energy collected. A series of tubes is secured to the panel, and water to be heated is circulated through these tubes to extract the heat received by the panel. The back of the panel is often insulated by a layer of insulating material such as glass, wool, or plastic foam.

In most cases, these panels include a frontal screen made of glass or transparent plastics material, such as transparent acrylic or PVC, which allows solar radiation to pass through the screen onto the panel and retains the heat by reducing losses caused by re-radiation or convection cooling.

The warmed water from solar panels is normally circulated through a separate tank so that the temperature may build up to a maximum value being a balance between the heat input and heat losses in the system. This water is then used as feed water for the main hot water tank, as hot water is drawn off from the system. As this water is generally only warm, except in very hot weather or when the panel is used in hot climates, it cannot be used directly as hot water, and a separate heater in the main hot water tank is necessary to heat the water to usable temperatures. It is also clear that water from the solar panel cannot be used generally for maintaining the temperature of the hot water in the main tank. An example of this type of renewable energy source can be found in U.S. Patent No. 4,089,957, issued to Bennett.

While these types of solar energy harnessing are efficient in their own capacity, they do not provide for an economical source of both thermal and electrical energy which can be utilized throughout households of the world.

A power panel according to the preamble of claim 1 is disclosed in JP H06 244445 A.

JP H09 144257 A discloses a solar battery module which is provided with a structure including sheet glasses stuck to each other through a resin sheet layer and solar battery cells, and a rear face-protective sheet stuck to the structure through the resin sheet layer so as to cover the rear face of the structure.

JP 2005 019655 A discloses a method for manufacturing an electrically heated hybrid panel composed of a laminated structure including a solar cell module and a heat collector.

WO 2009/046352 A2 discloses a power panel designed to incorporate a means of both thermal energy production and electrical energy production from the solar energy produced by the sun. The power panel comprises a synthetic molded enclosure and a transparent panel disposed on the synthetic molded enclosure. The transparent panel is adapted to insulate the thermal energy captured by the liquid circulating in the enclosure. The enclosure includes a plurality of segmented partitions adapted to form liquid pathways for channeling a liquid through the enclosure when the transparent panel is disposed on the segmented partitions thereby forming a liquid boundary in proximate contact with the segmented partitions and with the liquid in the enclosure.

### SUMMARY

It is therefore an object of the present technology to provide a power panel which may provide thermal energy and electrical energy from the conversion of the light emitted from the sun with increasing the thermal energy transferred across a PV cell tray being part of the power panel.

This object is achieved by the power panel according to claim 1.

These and other objects will become apparent from the present technology comprising a power panel designed to incorporate a means of both thermal energy production and electrical energy production from the solar energy produced by the sun. The panels can be utilized individually or linked together to provide a greater net energy production, depending upon the application. The individual panels are manufactured by a cost-effective, automotive-style manufacturing process already utilized in other fields, which would significantly lower consumer installed energy costs. The power panels are manufactured in three configurations: the first, a photovoltaic and thermal panel (PVT), which would provide 8%-40 watts of electrical energy and up to 500 watts of thermal energy per panel; a second, thermal-only power panel, which would provide up to 550 watts of thermal energy; and, lastly, a concentrated photovoltaic thermal panel (CPVT), which would provide 32%-240 watts of electrical energy and up to 300 watts of thermal energy per panel. All three embodiments vastly reduce the typical solar-per-watt costs and eliminate the problem of current tight supply of traditional silicon solar cells.

Further areas of applicability will become apparent from the description provided herein. It should be understood that the description and specific examples are intended for purposes of illustration only and are not intended to limit the scope of the present disclosure.

### DRAWINGS

The drawings described herein are for illustration purposes only and are not intended to limit the scope of the present disclosure in any way.
Figure 1 is a perspective view of the two linked power panels comprising the preferred embodiment of the present technology;
Figure 1A is a partial, cross-sectional side view of the connection element linking one or more power panels together;
Figure 2 is a partial perspective view of a prior art heat exchanger collector plate known in the art;
Figure 3 is an exploded, assemblage view of the components according to the present teaching;
Figure 3A is a top view of the enclosure illustrating a top surface of the enclosure shown in Figure 3.
Figure 3B is a partial plan view magnification of Figure 3A, illustrating the liquid pathways and vented air paths defined by the partitions and turning veins of the enclosure.
Figure 3C is a cross section view of two attached power panels in series.
Figure 3D is a cross section of a magnified corner portion of Figure 3C showing the relative position of the top cover, photovoltaic panel, and flow of liquid.
Figure 3E is a cross section of a magnified center portion of Figure 3C showing the relative position of the top cover, photovoltaic panel puck, and flow of liquid.
Figure 4 is a perspective view of the bottom surface of the enclosure element of the power panel of the present technology;
Figure 4A is a perspective view of an alternate embodiment of the power panel 10 with the photovoltaic panel placed within and on top of the enclosure;
Figure 5 is a perspective illustration of a plurality of power panels comprising the preferred embodiment of the present technology implemented in series upon a building structure;
Figure 6 is a top right perspective view of an assembled photovoltaic panel of the present disclosure;
Figure 7 is an exploded assembly view of a power panel having the photovoltaic panel of Figure 6;
Figure 8 is a top right perspective view of a photovoltaic panel tray of the present disclosure;
Figure 9 is a top right perspective view of the photovoltaic panel tray of Figure 8 after application of an adhesive layer;
Figure 10 is a top right perspective view of the photovoltaic panel tray of Figure 9 after application of bus bars and terminal strips;
Figure 11 is a top right perspective view of the photovoltaic panel tray of Figure 10 after application of a second adhesive layer;
Figure 12 is a top right perspective view of the photovoltaic panel tray of Figure 11 after installation of a first column of solar cells;
Figure 13 is a top right perspective view of the photovoltaic panel tray of Figure 12 after installation of a second column of solar cells;
Figure 14 is a top right perspective view of the photovoltaic panel tray of Figure 13 after installation of a third column of solar cells;
Figure 15 is a top right perspective view of the photovoltaic panel tray of Figure 14 after installation of a fourth column of solar cells;
Figure 16 is a top right perspective view of area 16 of Figure 15;
Figure 17 is a bottom right perspective view of the photovoltaic panel tray of Figure 6;
Figure 18 is a perspective view of a junction box of the present disclosure; and
Figure 19 is a perspective view of the junction box of Figure 18 after potting.

### DETAILED DESCRIPTION

The following description is merely exemplary in nature and is not intended to limit the present disclosure, application, or uses. It should be understood that throughout the drawings, corresponding reference numerals indicate like or corresponding parts and features.

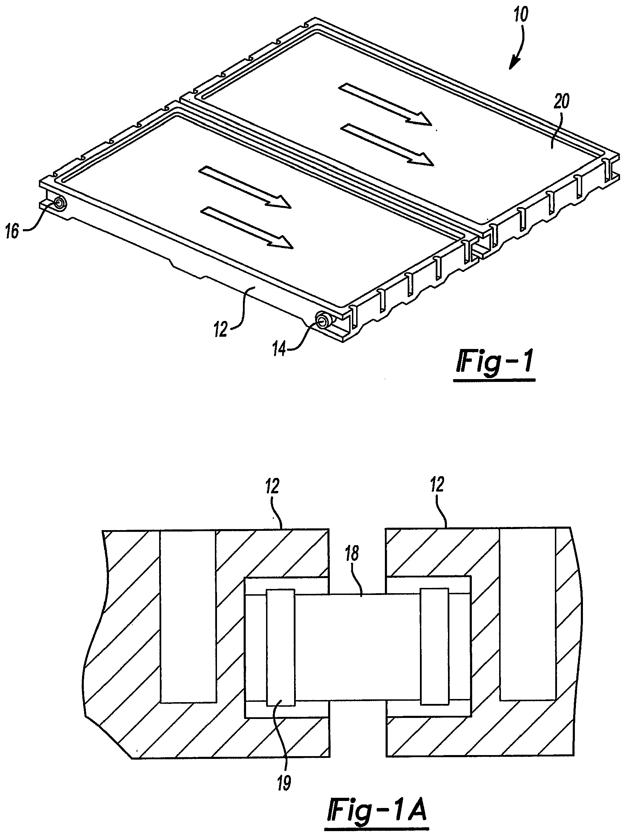

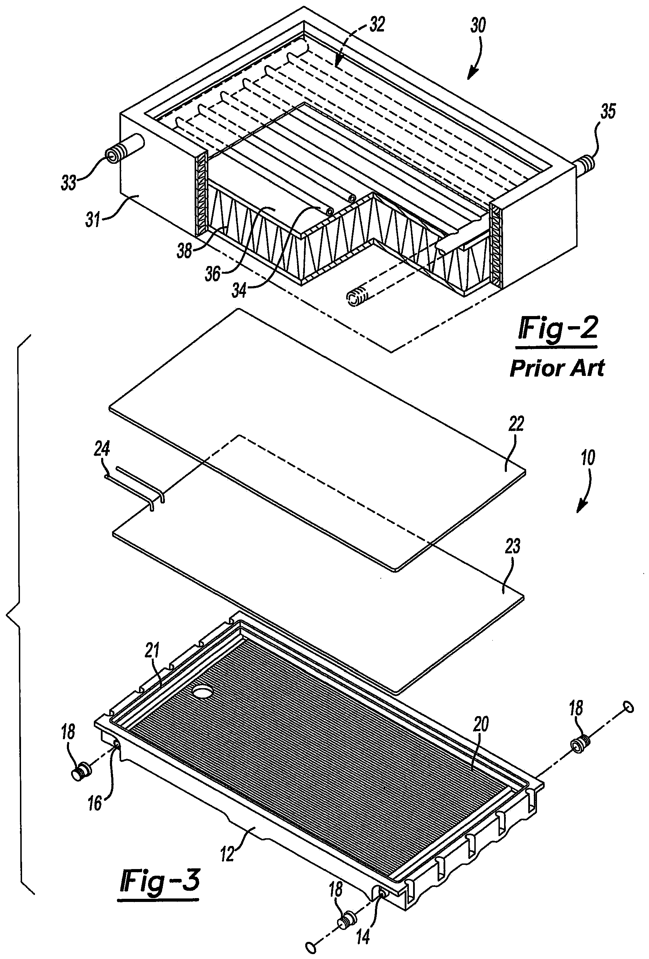

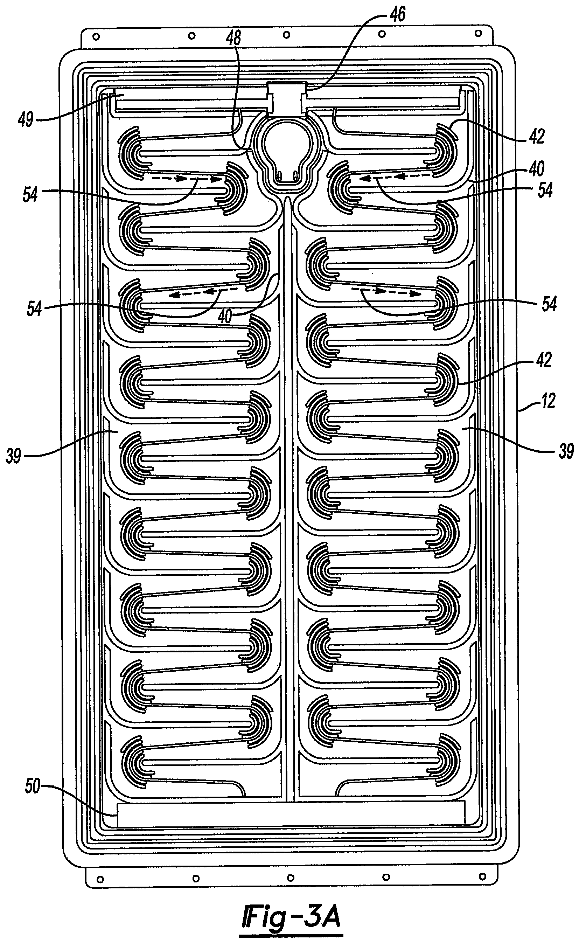

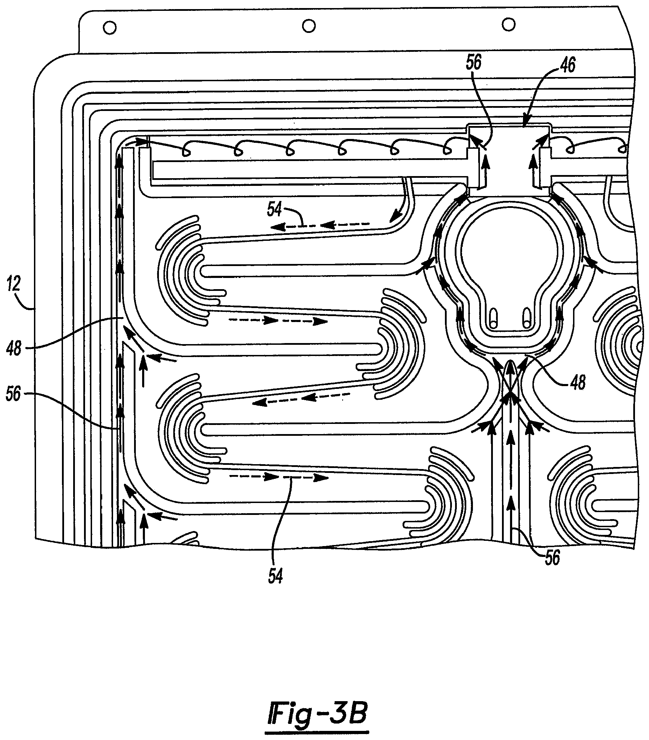

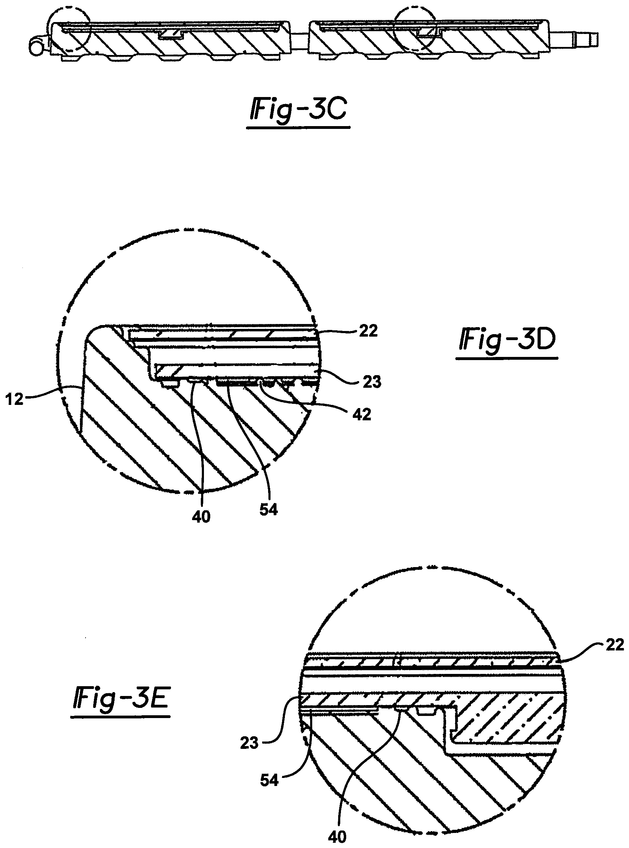

Referring now to the figures, particularly Figures 1, 1A, and 3, an embodiment of the present technology comprising a power panel 10 is shown. The power panel 10 comprises a generally rectangular-shaped, expanded polypropylene enclosure 12 having a solar energy absorption portion 20. The solar energy absorption portion 20 includes a series of longitudinal channels, indicated by the arrows of Figure 1. The channels are defined by parallel segmented partitions disposed on the top surface of the enclosure 12 through which liquid is conducted. The liquid, for example, distilled water, is pumped into the input port 16 wherein it travels through an input trough, which disperses the liquid evenly along the longitudinal channels. The liquid travels down the longitudinal channels of the absorption portion 20 and is collected in a lower, perpendicular output trough which directs the flow out to the output port 14.

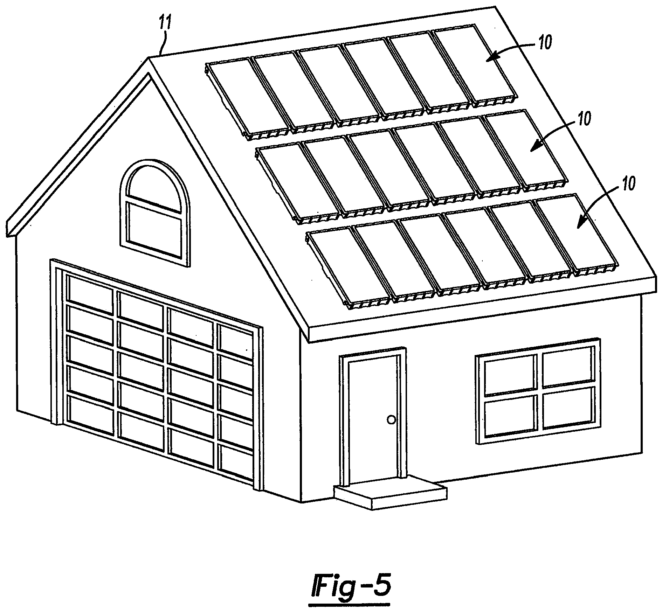

As stated, the power panel 10 can be installed as stand-alone units or can be linked together in series to form a larger energy-production means, for example a power generating panel array as shown in Figures 1 and 5. In order to link two or more panels 10 together, the enclosures 12 are molded so as to allow the input port 16 and output port 14 to align horizontally with adjacent panels. A journal conduit 18 connects adjacent input port 16 and output port 14 on adjacent power panels, wherein a sealing and securing means 19 is implemented between the conduit 18 and each enclosure input 16 or output 14 to ensure a secure, leak-free connection as shown in Figure 1A.

In some embodiments of the present technology, the power panel 10 can consist of a synthetic molded enclosure 12 comprising a solar radiation absorption top surface 20, a bottom surface, and sidewalls. The top absorption surface 20 of the enclosure 12 can be painted black to enhance solar radiation absorption and heat the liquid circulating on the top surface of the enclosure 12. The enclosure also includes a transparent panel 22 disposed on the enclosure 12. The transparent panel 22 is adapted to insulate the thermal energy contained within the enclosure 12. Liquid is channeled through the power panel 10 by adding a plurality of segmented partitions 40 which are adapted to form liquid pathways for channeling a liquid through the pathways when the transparent panel 22 is disposed on the segmented partitions 40, thereby forming a liquid boundary in proximate contact with the segmented partitions 40 and with the liquid in said enclosure 12.

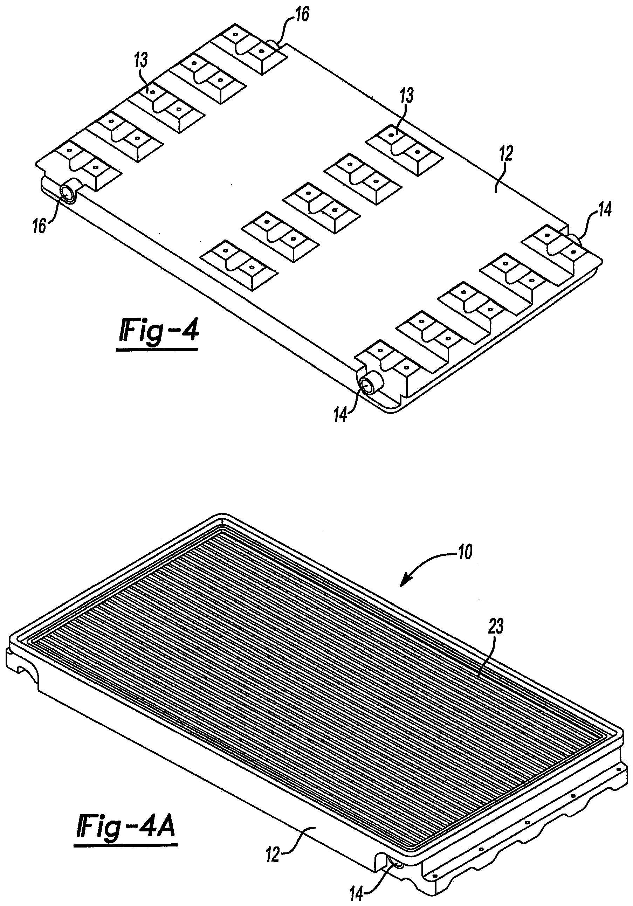

The power panel 10 can also be manufactured having an electrical generation, in addition to its thermal energy capture capability, by including a photovoltaic panel 23 as shown in Figures 4A and 3. The photovoltaic panel 23 can generate electrical power directly from the solar radiation contacting the surface of the power panel 10. The photovoltaic panel 23 forms a liquid boundary or "lid" that is in proximate contact with the liquid circulating through the enclosure 12. This contact between the photovoltaic panel 23 and the circulating liquid serves to provide a thermal and liquid seal between the enclosure 12 and the external environment, but also captures any incident heat generated by the solar cells disposed on the photovoltaic panel 23.

The power panel 10 described herein is superior over conventional flat plate heat exchange collectors 30 illustrated in Figure 2. These collectors 30 typically consist of an enclosure 31 having a liquid inlet 35, a liquid outlet 33, and a series of longitudinal liquid pipes 34 connecting the two. The longitudinal pipes 34 are generally copper and attached to a copper absorber plate 36, which absorbs the solar energy, transferring the heat to the liquid within the pipes 34. A cover sheet 32, typically made of glass, is implemented to protect the pipes 34 and absorber plate 36. The absorber plate 36 is insulated at 38 from the enclosure and structure to which the collector 30 is attached. The present power panel 10 is superior in design and efficiency over these prior art collectors in that the channels through which the liquid flows is molded into the enclosure 12 and is insulated from the outside of the enclosure 12 as well as the structure to which the power panel 10 is mounted.

In some embodiments of the present technology, best illustrated in Figures 3, 3A, and 3B, the power panel 10 is shown having an electric photovoltaic panel 23 which is comprised of a plurality of solar cells fitted over the absorption portion 20 of the enclosure 12. The type of photovoltaic panel 23 is not critical, other than the requirement that the photovoltaic panel 23 must be dimensioned to fit within the sides of enclosure 12 and form an insulating seal with respect to liquid flowing in contact with the photovoltaic panel 23. The number of solar cells disposed on the photovoltaic panel 23 is not critical. In some embodiments, suitable photovoltaic panels for use as the photovoltaic panel 23 of the present technology are also commercially available, e.g., the thin-film photovoltaic panel: EPV-42 sold by Energy Photovoltaics, Inc. (Robbinsville, NJ, USA). This allows for the collection of electrical energy, which is transferred through conduit 24 attached to the photovoltaic panel 23 to a remote power storage unit (not shown), as well as the collection of thermal energy from the channels of liquid flowing through the enclosure 12 below. The photovoltaic panel 23 serves as the top boundary for the liquid traveling through the liquid pathways 54 within the enclosure 12 and acts as an insulator for the fluid flow. A clear, tempered-glass top glazing 22 is fitted over the assembly and is not only sealed to the enclosure 12 by a weather-tight seal 21, yielding a closed system, but further insulates the assembly, providing much greater energy efficiency for the power panel 10.

Referring now to Figures 3, 3A, and 3B, the enclosure 12 is shown in plan view exposing the solar radiation exposed top surface. The enclosure 12 can be manufactured from a one-piece molded material. In general, the enclosure 12 is rectangular in shape. The enclosure 12 can be molded, for example, compression molded, from a synthetic material that is resistant to UV radiation and compatible with liquids such as water. In some embodiments, the enclosure 12 is molded from a thermoplastic polyolefin. In some embodiments, the thermoplastic polyolefin can include one or more well-known thermoplastic polyolefins comprising a mixture of polypropylene and an olefinic based rubber. In some embodiments, suitable compositions for use in compression molding of the enclosure 12 are also commercially available e.g., the thermoplastic polyolefin (TPO): SEQUEL E3000 sold by Solvay Engineered Polymers Inc. (Auburn Hills, MI, USA).

The top surface 39 of enclosure 12 also includes a plurality of segmented partitions 40 which are generally placed on the top surface 39 of enclosure 12. The segmented partitions 40 are placed on the top surface 20 to create liquid pathways 54 shown as dashed arrows in Figures 3A and 3B. The liquid pathways 54 originate from the inlet trough 49 and terminate at the outlet trough 50. The liquid pathways 54 are generally serpentine is shape but can be customized to form any shape as defined by the placement of the segmented partitions 40 and turning veins 42. As shown in Figure 3A, the top surface 39 is divided into two general regions, each region containing a plurality of segmented partitions 40 and a plurality of turning veins 42. In some embodiments, the generally L-shaped segmented partitions 40 as shown in Figure 3A can be separated by a distance ranging between 1.0 cm and about 10 cm. The top surface 39 is shown with two liquid pathways 54. However, it is envisioned, the arrangement of segmented partitions 40 and turning veins 42 to define different liquid pathways 54 that are adapted to channel a liquid through the enclosure in a predetermined manner can be modified. In general, the flow of liquid from the inlet trough 49 to the outlet trough 50 is dependent on gravity flow and the pitch of the power panel 10 on the surface of a solar radiation exposed surface, for example the slope of the roof on which the power panel 10 is attached in relation with the surface of the ground.

In some embodiments, the segmented partitions 40 and turning veins 42 are made from a structured sealant. The structured sealant is applied to the top surface 39 of molded enclosure 12 prior to the mounting of the photovoltaic panel 23 onto the enclosure. Once the photovoltaic panel 23 is mounted on the top surface 39 of enclosure 12, a contained space between the photovoltaic panel 23 and the top surface of enclosure 12 is formed. The segmented partitions 40 and turning veins 42 are disposed in the top surface 39 of enclosure 12 and have a height of about 0.01 mm and about 10.0 mm, providing a contained space between the photovoltaic panel 23 and the top surface 39 of enclosure 12 of about 0.01 mm to about 10 mm, more preferably from about 0.1 mm to about 5.0 mm, and still most preferably from about 0.125 mm to about 3.0 mm. The contained space between the photovoltaic panel 23 and the top surface 39 of enclosure 12 will provide liquid pathways that are defined by the segmented partitions 40 and the turning veins 42 as shown by the dashed arrows. The photovoltaic panel 23 is disposed on top of the segmented partitions 40 and turning veins 42, which aids in adhering the photovoltaic panel 23 to the enclosure 12. The segmented partitions 40 and turning veins 42 can be made from a structured sealant/adhesive having the adhesion and mechanical properties of urethane, along with the flexibility and ultraviolet radiation resistance of silicone. The structured sealant can comprise a single polymer or a mixture of polymers. In some embodiments, the structured sealant can include one or more silyl modified polymers. Silyl modified polymers are cross-linkable by treatment with a water/silanol condensation catalyst. Silyl modified polymers can include, for example, copolymers of ethylene, propylene, or 1-butene with unsaturated silane compounds; graft polymers prepared by grafting unsaturated hydrolysable silane compounds onto polyethylene or other suitable polymers; or polymers which have hydrolysable groups introduced therein by transesterification. Useful silyl modified polymers for use as the segmented partitions 40 and turning veins 42 are described in U.S. Patent Publication Number 2006/0036008, Serial Number 11/140,230, published Feb. 16, 2006.

In some embodiments, suitable structured sealant/adhesive compositions for use as the segmented partitions 40 and turning veins 42 disposed on the top surface 39 of enclosure 12 are also commercially available e.g., the moisture cured silyl modified polymer structured sealant: 940 FS sold by Bostik (Wauwatosa, WI, USA). Figure 3B shows in particular the liquid pathways 54 created by the segmented partitions 40 and turning veins 42 which are made from a structured sealant or adhesive. The segmented partitions 40 and turning veins 42 as shown in Figure 3B not only define liquid pathways 54 shown in dashed arrows, but also provide a path for air in the enclosure to escape to exterior of enclosure 12 through vented air flow paths as indicated by the solid arrows 56. Thus, the enclosure 12 also provides for ventilated air flow within the enclosure 12. In some embodiments, the volume of water circulated through enclosure 12 ranges from about 0.38 L/min (0.1 gal/min) to about 7.57 L/min (2.0 gal/min). In operation, the temperature of the circulating liquid, for example, water, can range from about 20°C to about 70°C.

As best illustrated in Figure 3B, a bridge 46 is mounted onto the top surface 39 of enclosure 12. Bridge 46 can be made from any material that is compatible with segmented partition 40 and can be mounted onto the top surface 39 of the enclosure 12. In some embodiments, the bridge 46 can be made from a thermoplastic polyolefin. Bridge 46 connects the venting system of enclosure 12 to a reservoir (not shown) attached to the power panel 10. The bridge 46 is adapted to release the air present in the enclosure 12 along air flow path marked by the solid arrows 56 to exit the enclosure 12 and into the reservoir (not shown). Bridge 46, when properly bonded to the enclosure 12 and sealed to the photovoltaic panel 23 (using a segmented partition 40), acts as a snorkel when power panel 10 is laid at an angle. The bridge 46 allows the evacuated air to flow to a point higher than the water level in the inlet trough 49, while also keeping the water out of the air venting system. Due to the different densities found in the liquid and the air, as the power panel 10 fills with water, air is pushed through these corners and evacuate 'up' and then over bridge 46, into the volume of air in the inlet trough 49. Figures 3D-3E illustrate the general top surface layers of power panel 10. As shown in Figures 3D-3E, the partitions 40 and turning veins 42 along with photovoltaic panel 23 define the walls for channels or flow paths 54 for the passage of liquid. The present enclosure advantageously provides the flow of liquid through flow paths 54 from a first end of enclosure 12 to a second end of enclosure 12. The passage of liquid through flow paths 54 enables the collection of heat incident to the sun's rays. Furthermore, heat emitting from the photovoltaic panel 23 which is in contact with liquid in flow paths 54 is collected by the liquid and improves the efficiency of the photovoltaic panel 23. In addition, as illustrated in Figures 3B, 3D and 3E the partitions 40 provide a path for air to vent and equilibrate the power panel 10. Flow of venting air is shown as solid arrows 56. Thus, the arrangement and position of the partitions and turning veins 42 define flow paths 54 and 56 which improve the efficiencies of the heat collection and air flow within the enclosure 12. The vented air eventually travels up through the panel 10 and exits through the bridge 46.

In some embodiments, the segmented partitions 40 can be linear and in horizontal rows, where the path of liquid flow is vertical with respect to the inlet trough 49 and the outlet trough 50. As shown in Figure 4A, the alternative embodiment comprises a plurality of parallel segmented partitions 40. The enclosure is sealed with the placement of a photovoltaic panel 23 on top and in contact with the segmented partitions 40. The photovoltaic panel 23 is then overlayed with a transparent panel 22 to protect the solar cells disposed on the solar radiation exposed surface of photovoltaic panel 23.

The enclosure 12 has great chemical and weather-resistance and may be attached alone or in series to a multitude of surfaces, providing they fall within the preset slope parameters, allowing the liquid to flow efficiently through the power panel 10. As shown in Figure 4, a plurality of raised platforms 13 are molded into the enclosure 12 bottom, allowing the mounting of the power panel 10 to the desired solar radiation exposed surface (for example, a roof of a dwelling or commercial property, a mounted post with an attached board facing the solar radiation and the like) via simple lag screws. A power generating panel array operable to generate hot water and solar derived electrical energy can be made using the power panel 10 described herein. The power panel 10 can be installed in a series of 1 by X, in any number allowable for the given area along the solar radiation exposed surface of any structure 11, as illustrated in Figure 5.

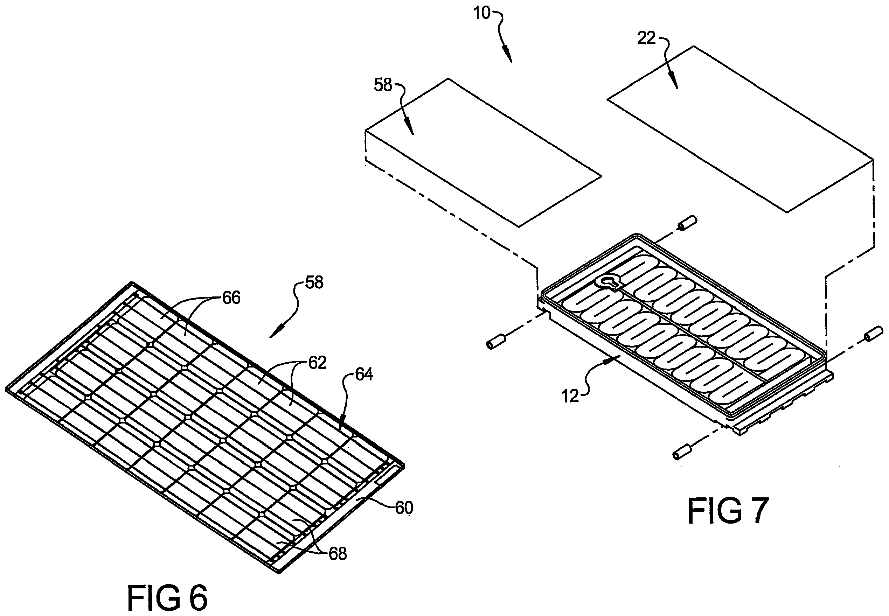

Referring to Figure 6, a photovoltaic (PV) panel 58 for a power panel of the present disclosure includes a PV cell tray 60 which according to several embodiments is made from an aluminum material having an anodized coating. A plurality of photovoltaic cells 62 are fixedly connected to PV cell tray 60, each having a plurality of bus bars 64 that are interconnected in series to adjoining photovoltaic cells 62. The plurality of photovoltaic cells 62 is arranged in each of a plurality of cell rows 66 and a plurality of cell columns 68. According to several embodiments, each photovoltaic panel 58 includes 28 photovoltaic cells 62 arranged in four (4) columns.

Referring to Figure 7, assembled photovoltaic panels 58 are attached at an upper surface of enclosure 12 as previously described herein. The transparent panel 22 is then disposed above the photovoltaic panel 58 and spaced therefrom. Installation of the transparent panel 22 and the photovoltaic panel 58 completes the assembly of a power panel 10.

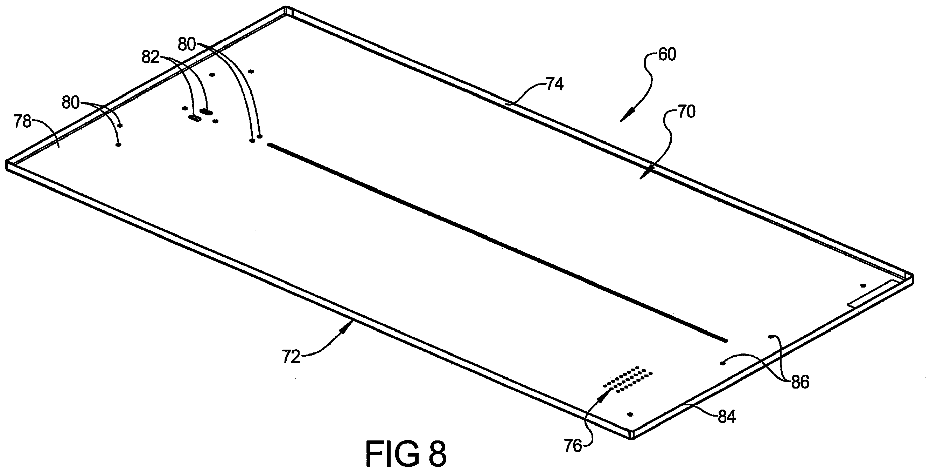

Referring to Figure 8, individual PV cell trays each include an upper first face 70 which is substantially planar and an oppositely directed lower second face 72. A raised outer wall 74 which is raised with respect to upper first face 70 defines an outer perimeter wall of PV cell tray 60. Raised outer wall 74 can be an integral extension of the material of first face 70 and second face 72, and according to several embodiments is oriented perpendicular to upper first face 70. A plurality of dimples 76 forming a pattern of raised surfaces and cavities are created at least on second face 72 to assist in creating turbulent flow of a fluid which is in contact with lower second face 72. Dimples 76 therefore help increase the thermal energy transferred across PV cell tray 60.

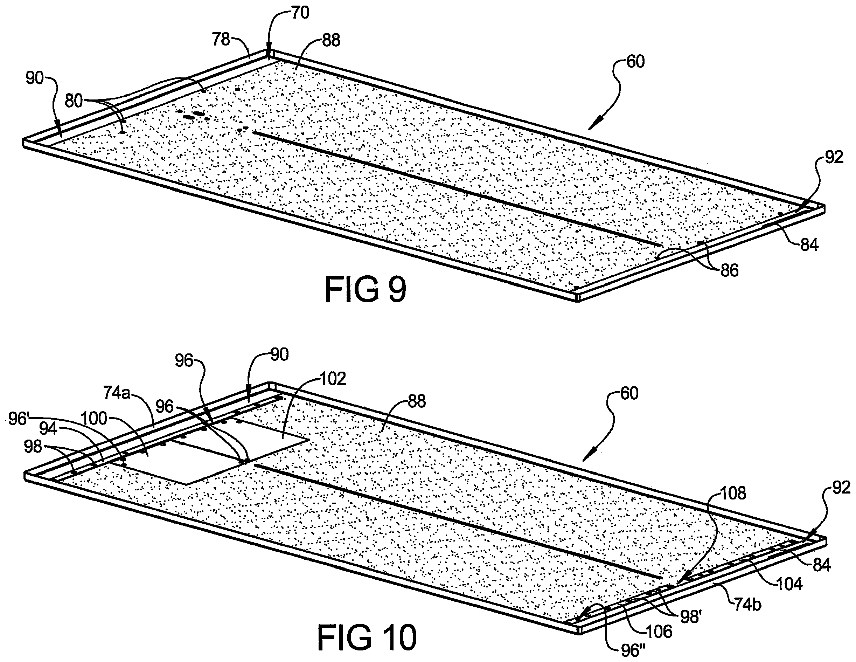

PV cell tray 60 further includes a tray first end 78 having a plurality of first raised nodules 80 created from the material of upper first face 70 and extending above upper first face 70, located proximate to tray first end 78. Power transfer wire apertures 82 are also provided proximate to tray first end 78 to permit power leads collecting the energy of photovoltaic cells 62 to be routed from first face 70 to a second face 72 side. A tray second end 84 has a plurality of second raised nodules 86, similar to first raised nodules 80, which are raised above upper first face 70 and are located proximate to tray second end 84. Each of the first and second raised nodules 80, 86 are positioned at predefined locations whose purpose will be better described in reference to Figure 10. Each of the first and second raised nodules 80, 86 are also dimensionally controlled and can be provided, for example, by a stamping process acting on lower second face 72 to push material away from first face 70 when PV cell tray 60 is manufactured.

Referring to Figure 9, in a first assembly step to create photovoltaic panels of the present disclosure, a first layer of adhesive 88 is applied, for example by a spraying or rolling operation onto upper first face 70 of PV cell tray 60. First layer of adhesive 88 is applied to substantially all of the upper first face 70 with the exception of first and second uncoated portions 90, 92 which are rectangular in shape and are located at tray first end 78 and tray second end 84. First layer of adhesive 88 also covers each of the first and second raised nodules 80, 86. According to several embodiments, the material of first layer of adhesive 88 can be Dow Corning® Cell Encapsulant PV-6010 material which is a two-part silicone encapsulant applied as a flowable liquid. Other types of adhesive materials can also be used for first layer of adhesive 88 which have properties adapted for adhesion to solar cells and are substantially transparent or clear.

Referring to Figure 10 and again to Figure 8, after a time period permitting material of first layer of adhesive 88 to cure, a first energy collection strip 94 made for example of an aluminum material having an anodized coating to reduce oxidation of the aluminum material, is applied onto first layer of adhesive 88. Individual ones of multiple alignment apertures 96 extending through first energy collection strip 94 are co-axially aligned with and receive individual ones of the first raised nodules 80. Receipt of first raised nodules 80 in the alignment apertures 96 positions the first energy collection strip 94 at a predefined location on PV cell tray 60 proximate to but not extending into first un-coated portion 90. Either prior to or following application of first energy collection strip 94, a plurality of ribbon connection areas 98 are created on an outside-facing surface of first energy collection strip 94. Ribbon connection areas 98 can be created for example using a spot-face operation which locally removes the anodized material coating from a surface of first energy collection strip 94, thereby leaving un-coated aluminum material at locations used for subsequent electrical connection of the photovoltaic cells.

Following or during the application of first energy collection strip 94, each of a first and second bus plate 100, 102 are applied onto first layer of adhesive 88 abutting or proximate to each other and also proximate to but not directly contacting first energy collection strip 94. Similar to first energy collection strip 94, each of the first and second bus plates 100, 102 can include at least one and according to several embodiments a plurality of alignment apertures 96' which also receive individual ones of the first raised nodules 80 to align the first and second bus plates 100, 102 at predefined positions on PV cell tray 60.

At PV cell tray second end 84, each of a second and a third energy collection strip 104, 106 are applied to first layer of adhesive 88. A gap 108 is retained between proximate ends of the second and third energy collection strips 104, 106 to prevent electrical shorting between second and third energy collection strips 104, 106. Similar to first energy collection strip 94, each of the second and third energy collection strips 104, 106 also include one or more alignment apertures 96" which co-axially align with individual ones of the second raised nodules 86, shown and described in reference to Figure 8, which are used for the similar purpose of positioning each of the second and third energy collection strips 104, 106 at predefined locations on PV cell tray 60. Each of the second and third energy collection strips 104, 106 are positioned out of second un-coated portion 92 of PV cell tray 60. According to several embodiments, second and third energy collection strips 104, 106 are longitudinally aligned with each other and are both oriented parallel with respect to first energy collection strip 94. Also, according to several embodiments, each of the first, second, and third energy collection strips 94, 104, 106 are made from an electrically conductive metal such as 3003 H14 aluminum which has a hard coat anodized material applied thereto to minimize oxidation. Similar to first energy collection strip 94, each of the second and third energy collection strips 104, 106 also include at least one and according to several embodiments multiple ribbon connection areas 98', where anodized material is locally removed, leaving exposed aluminum surfaces for subsequent electrical connection of the photovoltaic cells to individual ones of the second and third energy collection strips 104, 106.

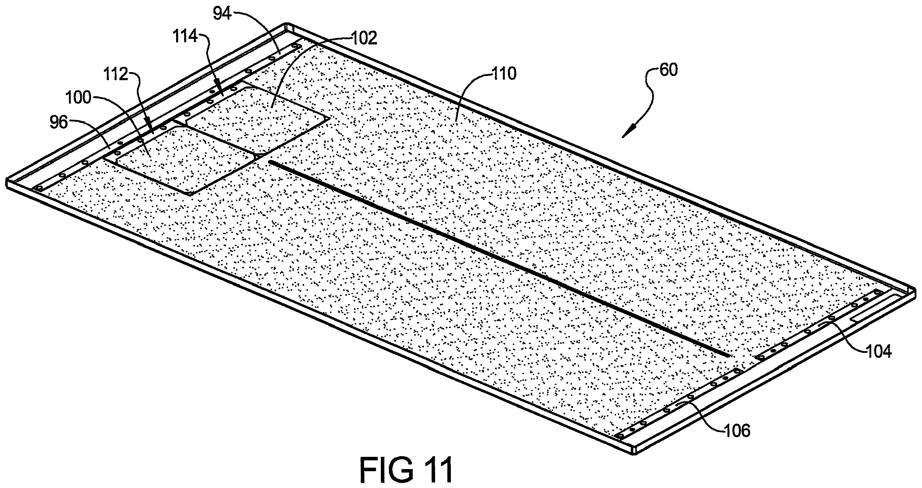

Referring to Figure 11, following application of the second and third energy collection strips 104, 106, a second layer of adhesive 110 is applied over the second and third energy collection strips 104, 106. Material of second layer of adhesive 110 can be the same as the material of first layer of adhesive 88. The second layer of adhesive 110 is omitted at first and second bus plate uncoated portions 112, 114 of each of the first and second bus plates 100, 102. First and second bus plate uncoated portions 112, 114 are provided to allow electrical connection of individual ones of the photovoltaic cells.

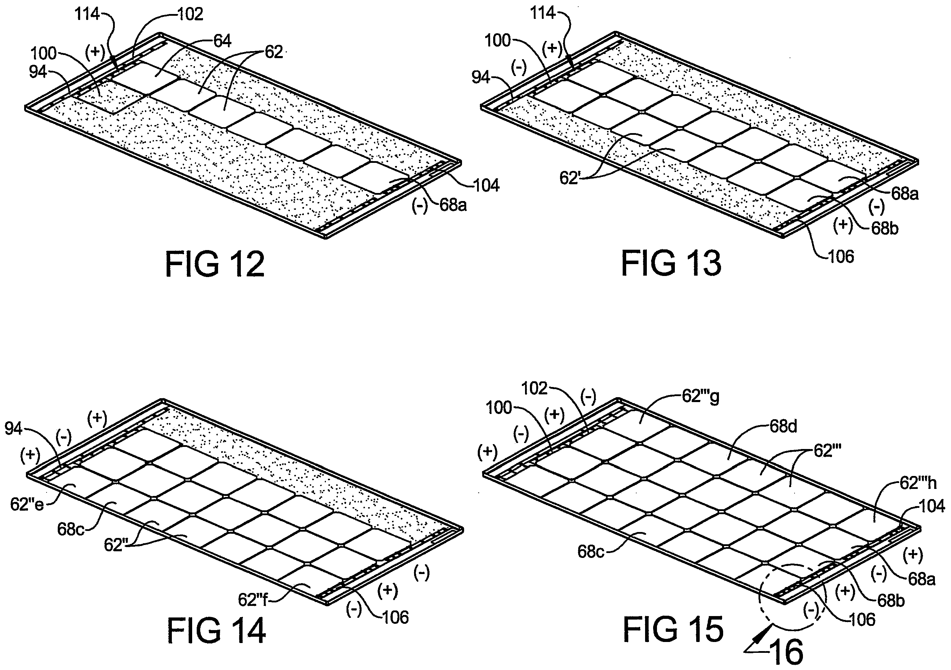

Referring to Figure 12, according to several embodiments photovoltaic cells 62 can be Bosch Solar Cells M 3BB, C3 1220 provided by Bosch Solar Energy AG, Erfurt, Germany. Photovoltaic cells 62 are electrically connected to adjacent cells in series to create a first cell column 68a. First cell column 68a can be created in an electrical connection operation remote from PV cell tray 60 and applied as an entire unit to first face 70. The individual photovoltaic cells 62 of first cell column 68a are aligned as shown such that the electrical connection tabs or flexible ribbons at a defined positive end of cell column 68a of a photovoltaic cell 62a is electrically connected to second bus plate 102 at second bus plate uncoated portion 114. The electrical connection tabs or flexible ribbons of a photovoltaic cell 62b defining an opposite negative end of cell column 68a are electrically connected to second energy collection strip 104.

Referring to Figure 13, a second cell column 68b is created remote from PV cell tray 60 similar to first cell column 68a. A photovoltaic cell 62'c is electrically connected to first bus plate uncoated portion 112 of first bus plate 100. A photovoltaic cell 62'd is then electrically connected to third energy collection strip 106. The electrical orientation of the photovoltaic cells of second cell column 68b are reversed from those of first cell column 68a such that the negative cell end connections of second cell column 68b are connected at first bus plate uncoated portion 112 and the positive cell end connections of photovoltaic cell 62'd are connected to third energy collection strip 106.

Referring to Figure 14, a third cell column 68c of photovoltaic cells 62" are located outward of second cell column 68b and have their positive and negative terminal ends reversed from the photovoltaic cells of second cell column 68b. A photovoltaic cell 62"e of third cell column 68c is connected to first energy collection strip 94. A photovoltaic cell 62"f of third cell column 68c is electrically connected to third energy collection strip 106.

Referring to Figure 15, to complete the installation of photovoltaic cells 62 of photovoltaic panel 58, a fourth cell column 68d has the positive and negative orientation of its photovoltaic cells reversed with respect to those of first cell column 68a. A photovoltaic cell 62"'g is electrically connected to first energy collection strip 94. A photovoltaic cell 62"'h of fourth cell column 68d is electrically connected to second energy collection strip 104.

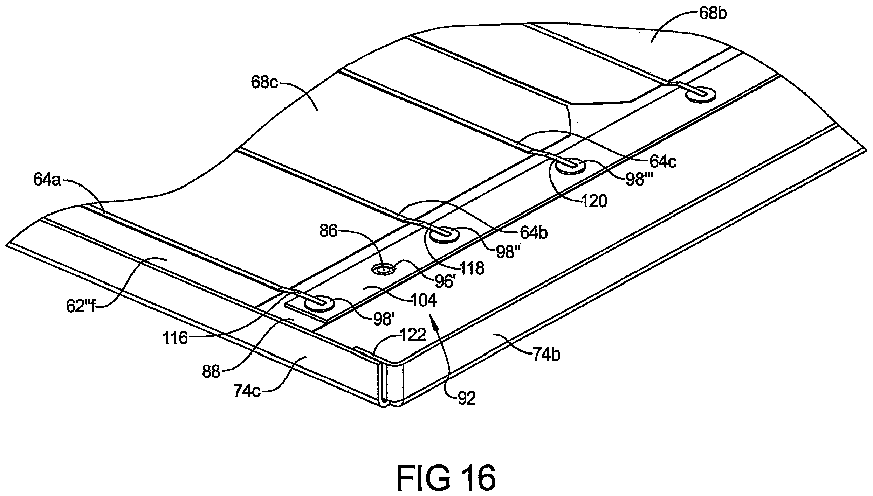

Referring to Figure 16, the exemplary electrical connections used to connect the photovoltaic cells includes use of first, second, and third flexible ribbons 116, 118, 120 which have flexible ribbons individually connected to a bus bar 64a, 64b, and 64c of photovoltaic cell 62"f of third cell column 68c. A first flexible ribbon 116 is connected using a spot-welding, contact-welding or similar joining procedure to ribbon connection area 98' of third energy collection strip 106. Similarly, a second flexible ribbon 118 extending from bus bar 64b is fixedly connected to ribbon connection area 98", and a third flexible ribbon 120 is electrically connected to ribbon connection area 98"'. Also clearly visible in this view is one of the second raised nodules 86 which is received in co-axial alignment with aperture 96' of third energy collection strip 106. According to several embodiments, the individual perimeter wall sections of raised outer wall 74, such as raised outer wall section 74b and raised outer wall section 74c, can be joined using a wall connection portion 122. Wall connection portion 122 can be an extension of either of raised outer wall portion 74b or 74c and can be welded to the proximate one of the raised outer wall portions. Raised outer wall 74 is provided for several reasons. These can include, but are not limited to, the stiffening properties provided by raised outer wall 74 which is oriented substantially perpendicular to upper first face 70 of PV cell tray 60. Raised outer wall 74 also provides a boundary preventing overflow of first layer of adhesive 88 during application of first layer of adhesive 88.

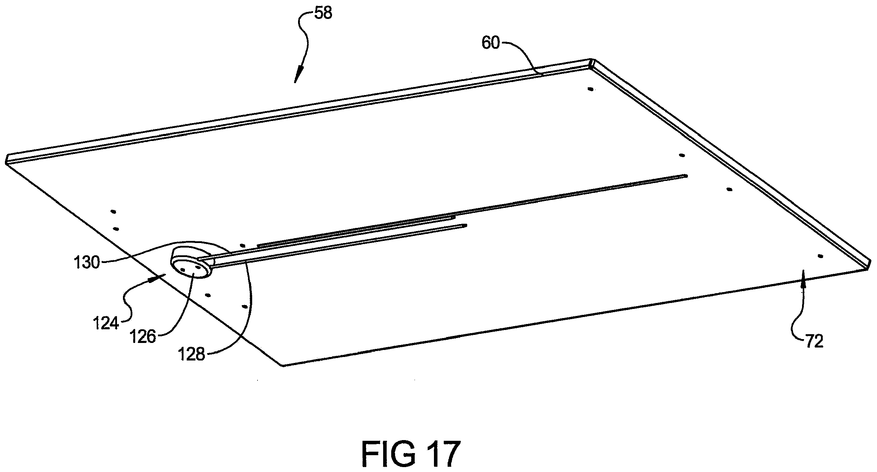

Referring to Figure 17 and again to Figures 6 and 8, after the installation of the photovoltaic cells 62 is complete onto upper first face 70 of PV cell tray 60, wire leads connected to various ones of first and second bus plates 100, 102 and first energy collection strip 94 are routed through wire apertures 82 into a junction box assembly 124 which is mounted on lower second face 72. The various wire leads are collected in a junction box 126 and first and second power leads 128, 130 extend outwardly from junction box 126 to route to a power panel (not shown) collecting power from one or more of the photovoltaic panels 58.

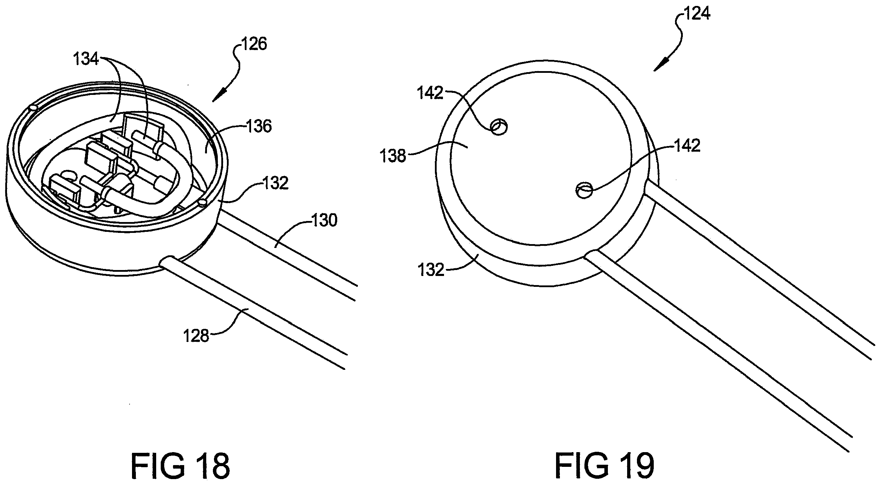

Referring to Figure 18, junction box 126 includes a junction box body 132 wherein a plurality of connection wires 134 are routed in a cavity 136 of junction box 126. First and second power leads 128, 130 are stripped and electrically connected within cavity 136.

Referring to Figure 19, to complete the junction box assembly 124, a junction box cover 138 is applied to junction box body 132. A fill aperture 140 is provided in junction box cover 138 for injection of a potting material (not shown) into the cavity of junction box body 132. A vent aperture 142 is also provided in junction box cover 138 to allow venting during the potting material fill operation.

## Claims

1. A power panel (10) for generating thermal and electric energy from solar radiation, the power panel (10) comprising:
a transparent panel (22) facing a source of the solar radiation;
a photovoltaic (PV) panel (58) for generating electrical power positioned on an opposite side of the transparent panel (22) from the source of the solar radiation, the photovoltaic panel (58) including:
a PV cell tray (60) having a first face (70) directed toward the source of the solar radiation;
a first layer of an adhesive (88) applied to the first face (70) of the PV cell tray (60); and
multiple solar cells (62, 62', 62", 62"') fixedly connected to the PV cell tray first face (70) by the first layer of the adhesive (88),
**characterized in that** the solar cells (62, 62', 62", 62"') are arranged in series in individual cell columns (68a, 68b, 68c, 68d),
wherein the power panel (10) further includes a synthetic molded enclosure (12) comprising a solar radiation top surface (20), bottom surface and sidewalls, the PV cell tray (60) positioned in contact with the synthetic molded enclosure (12) and spaced above the top surface (20), the PV cell tray (60) having a second face (72) oppositely directed with respect to the first face (70) in contact with a fluid flowing on the top surface; and
wherein at least the second face (72) includes a plurality of dimples (76) forming a pattern of raised surfaces aiding in development of turbulent flow of the fluid.

2. The power panel (10) for generating thermal and electric energy from solar radiation of Claim 1, further including a first energy collection strip (94) connected proximate a first end (78) of the PV cell tray (60), and second and third energy collection strips (104, 106) both positioned proximate to a second end (84) of the PV cell tray (60), each of the energy collection strips (94, 104, 106) positioned outside of the cell columns (68a, 68b, 68c, 68d) and fixedly connected to the PV cell tray (60) by the first layer of the adhesive (88).

3. The power panel (10) for generating thermal and electric energy from solar radiation of Claim 2, further including first and second bus plates (100, 102) directly attached to the first layer of the adhesive (88) and having an individual one of the solar cells fixed to one of the first or second bus plates (100, 102) using a second layer of the adhesive (110) applied to both the first and second bus plates (100, 102).

4. The power panel (10) for generating thermal and electric energy from solar radiation of Claim 3, wherein the individual cell columns (68a, 68b, 68c, 68d) comprise first, second, third and fourth cell columns each having a positive connection end and a negative connection end, and wherein:
the positive connection end of the first cell column (68a) is connected to the second bus plate (102) and the negative connection end of the first cell column (68a) is connected to the second energy collection strip (104); and
the negative connection end of the second cell column (68b) is connected to the first bus plate (100) and the positive connection end of the second cell column (68b) is connected to the third energy collection strip (106).

5. The power panel (10) for generating thermal and electric energy from solar radiation of Claim 4, wherein:
the positive connection end of the third cell column (68c) is connected to the first energy collection strip (94) and the negative connection end of the third cell column (68c) is connected to the third energy collection strip (106); and
the negative connection end of the fourth cell column (68d) is connected to the first energy collection strip (94) and the positive connection end of the fourth cell column (68d) is connected to the second energy collection strip (104).

6. The power panel (10) for generating thermal and electric energy from solar radiation of Claim 3, wherein the second layer of the adhesive (110) is applied to the first and second bus plates (100, 102) except at a first bus plate un-coated portion (90) and a second bus plate un-coated portion (92), the first and second bus plate un-coated portions positioned proximate to the first energy collection strip (94).

7. The power panel (10) for generating thermal and electric energy from solar radiation of Claim 3, further including:
first nodules (80) extending away from the first face (70) positioned proximate the first end (78) of the PV cell tray (60); and
multiple alignment apertures (96, 96') created in each of the first energy collection strip (94) and the first and second bus plates (100, 102), the first nodules (80) individually received in individual ones of the alignment apertures (96, 96') to fix positions of the first energy collection strip (94) and the first and second bus plates (100, 102).

8. The power panel (10) for generating thermal and electric energy from solar radiation of Claim 3, further including:
second nodules (86) extending away from the first face (70) positioned proximate the second end (84) of the PV cell tray (60); and
multiple alignment apertures (96") created in each of the second and third energy collection strips (104, 106), the second nodules (86) individually received in individual ones of the alignment apertures (96") to fix positions of the second and third energy collection strips (104, 106).

9. The power panel (10) for generating thermal and electric energy from solar radiation of Claim 1:
wherein the PV cell tray (60) includes a second face (72) oppositely directed with respect to the first face (70); and
a thermal portion of the solar radiation is transferred to a fluid in direct contact with the PV cell tray second face (72).

10. The power panel (10) for generating thermal and electric energy from solar radiation of Claim 1, further including:
a transparent panel (22) positioned in direct contact with the synthetic molded enclosure side walls and spaced above the photovoltaic panel (58), the transparent panel (22) acting to insulate thermal energy contained within the enclosure (12).

11. The power panel (10) for generating thermal and electric energy from solar radiation according to Claim 10, further including a first energy collection strip (94) located at a first end of the array and a second energy collection strip (104) located at an opposite second end of the array, the first and second energy collection strips (94, 104) connected to the tray first face (70) using the first layer of the adhesive (88).

12. The power panel (10) for generating thermal and electric energy from solar radiation according to claim 11, further including a second layer of the adhesive (110) applied directly on the solar cells (62, 62', 62", 62"'), the first and second energy collection strips (94, 104) being free of the second layer of the adhesive (110).

13. The power panel (10) for generating thermal and electric energy from solar radiation according to Claim 10, wherein the solar cells (62, 62', 62", 62"') have multiple bus bars (64a, 64b, 64c) each having a flexible ribbon (116, 118, 120) extending away from the bus bars (64a, 64b, 64c) to electrically connect proximate ones of the solar cells (62, 62', 62", 62"').

14. The power panel (10) for generating thermal and electric energy from solar radiation according to claim 10, wherein the enclosure (12) includes at least one inlet port (49) and at least one outlet port (50) configured to provide an inlet and an outlet for a fluid to pass into and out of the enclosure (12) between the top surface (20) and the second face (72) of the PV cell tray (60).

## Patentansprüche

1. Leistungspanel (10) zum Erzeugen von thermischer und elektrischer Energie aus Sonnenstrahlung, wobei das Leistungspanel (10) umfasst:
ein transparentes Panel (22), das einer Quelle der Sonnenstrahlung zugewandt ist;
ein photovoltaisches (PV) Panel (58) zum Erzeugen von elektrischer Leistung, das auf einer der Quelle der Sonnenstrahlung entgegengesetzten Seite des transparenten Panels (22) angeordnet ist, wobei das photovoltaische Panel (58) enthält:
ein PV-Zellträger (60) mit einer ersten Fläche (70), die in Richtung der Quelle der Sonnenstrahlung gerichtet ist;
eine erste Schicht aus Klebstoff (88), die auf die erste Fläche (70) des PV-Zellträgers (60) aufgebracht ist; und
mehrere Solarzellen (62, 62', 62", 62'"), die mit der ersten Fläche (70) des PV-Zellträgers durch die erste Schicht aus Klebstoff (88) fest verbunden sind,
**dadurch gekennzeichnet, dass** die Solarzellen (62, 62', 62", 62"') in Serie in einzelnen Zellspalten (68a, 68b, 68c, 68d) angeordnet sind,
wobei das Leistungspanel (10) ferner ein synthetisches, geformtes Gehäuse (12) aufweist, das eine Sonnenstrahlungs-Oberfläche (20), eine Bodenfläche und Seitenwände umfasst, wobei der PV-Zellträger (60) in Kontakt mit dem synthetischen, geformten Gehäuse (12) positioniert und in einem Abstand oberhalb der Oberfläche (20) angeordnet ist, der PV-Zellträger (60) eine zu der ersten Fläche (70) entgegengesetzt gerichtete zweite Fläche (72) in Kontakt mit einem auf der Oberfläche strömenden Fluid hat; und
wobei mindestens die zweite Fläche (72) eine Vielzahl von Vertiefungen (76) aufweist, die ein Muster erhabener Flächen bilden, die die Entwicklung einer turbulenten Strömung des Fluids fördern.

2. Leistungspanel (10) zum Erzeugen von thermischer und elektrischer Energie aus Sonnenstrahlung nach Anspruch 1, ferner enthaltend einen ersten Energiesammlungsstreifen (94), der nahe einem ersten Ende (78) des PV-Zellträgers (60) angeschlossen ist, und einen zweiten und einen dritten Energiesammlungsstreifen (104, 106), die beide nahe einem zweiten Ende (84) des PV-Zellträgers (60) angeordnet sind, wobei jeder der Energiesammlungsstreifen (94, 104, 106) außerhalb der Zellspalten (68a, 68b, 68c, 68d) angeordnet und mit dem PV-Zellträger (60) durch die erste Schicht aus Klebstoff (88) fest verbunden ist.

3. Leistungspanel (10) zum Erzeugen von thermischer und elektrischer Energie aus Sonnenstrahlung nach Anspruch 2, ferner enthaltend eine erste und eine zweite Busplatte (100, 102), die direkt an der ersten Schicht aus Klebstoff (88) angebracht, wobei eine einzelne der Solarzellen an der ersten oder der zweiten Busplatte (100, 102) unter Verwendung einer zweiten Schicht aus Klebstoff (110), die sowohl auf der ersten als auch auf der zweiten Busplatte (100, 102) aufgebracht ist, befestigt ist.

4. Leistungspanel (10) zum Erzeugen von thermischer und elektrischer Energie aus Sonnenstrahlung nach Anspruch 3, wobei die einzelnen Zellspalten (68a, 68b, 68c, 68d) eine erste, eine zweite, eine dritte und eine vierte Zellspalte umfassen, die jeweils ein positives Anschlussende und ein negatives Anschlussende aufweisen, und wobei:
das positive Anschlussende der ersten Zellspalte (68a) mit der zweiten Busplatte (102) verbunden ist und das negative Anschlussende der ersten Zellspalte (68a) mit dem zweiten Energiesammlungsstreifen (104) verbunden ist; und
das negative Anschlussende der zweiten Zellspalte (68b) mit der ersten Busplatte (100) verbunden ist und das positive Anschlussende der zweiten Zellspalte (68b) mit dem dritten Energiesammlungsstreifen (106) verbunden ist.

5. Leistungspanel (10) zum Erzeugen von thermischer und elektrischer Energie aus Sonnenstrahlung nach Anspruch 4, wobei:
das positive Anschlussende der dritten Zellspalte (68c) mit dem ersten Energiesammlungsstreifen (94) verbunden ist und das negative Anschlussende der dritten Zellspalte (68c) mit dem dritten Energiesammlungsstreifen (106) verbunden ist; und
das negative Anschlussende der vierten Zellspalte (68d) mit dem ersten Energiesammlungsstreifen (94) verbunden ist und das positive Anschlussende der vierten Zellspalte (68d) mit dem zweiten Energiesammlungsstreifen (104) verbunden ist.

6. Leistungspanel (10) zum Erzeugen von thermischer und elektrischer Energie aus Sonnenstrahlung nach Anspruch 3, wobei die zweite Schicht aus Klebstoff (110) außer an einem unbeschichteten Abschnitt (90) der ersten Busplatte und an einem unbeschichteten Abschnitt (92) der zweiten Busplatte auf die erste und die zweite Busplatte (100, 102) aufgebracht ist, wobei die unbeschichteten Abschnitte der ersten und der zweiten Busplatte nahe dem ersten Energiesammlungsstreifen (94) angeordnet sind.

7. Leistungspanel (10) zum Erzeugen von thermischer und elektrischer Energie aus Sonnenstrahlung nach Anspruch 3, ferner enthaltend:
von der ersten Fläche (70) abstehende erste Knötchen (80), die nahe dem ersten Ende (78) des PV-Zellträgers (60) angeordnet sind; und
mehrere Ausrichtöffnungen (96, 96'), die jeweils in dem ersten Energiesammlungsstreifen (94) und der ersten und der zweiten Busplatte (100, 102) gebildet sind, wobei die ersten Knötchen (80) einzeln in einzelnen der Ausrichtöffnungen (96, 96') aufgenommen sind, um den ersten Energiesammlungsstreifen (94) und die erste und die zweite Busplatte (100, 102) fest zu positionieren.

8. Leistungspanel (10) zum Erzeugen von thermischer und elektrischer Energie aus Sonnenstrahlung nach Anspruch 3, ferner enthaltend:
von der ersten Fläche (70) abstehende zweite Knötchen (86), die nahe dem zweiten Ende (84) des PV-Zellträgers (60) angeordnet sind; und
mehrere Ausrichtöffnungen (96"), die jeweils in dem zweiten und dem dritten Energiesammlungsstreifen (104, 106) gebildet sind, wobei die zweiten Knötchen (86) einzeln in einzelnen der Ausrichtöffnungen (96") aufgenommen sind, um den zweiten und den dritten Energiesammlungsstreifen (104, 106) fest zu positionieren.

9. Leistungspanel (10) zum Erzeugen von thermischer und elektrischer Energie aus Sonnenstrahlung nach Anspruch 1:
wobei der PV-Zellträger (60) eine zweite Fläche (72) aufweist, die entgegengesetzt zur ersten Fläche (70) gerichtet ist; und
ein thermischer Anteil der Sonnenstrahlung auf ein Fluid in direktem Kontakt mit der zweiten Fläche (72) des PV-Zellträgers übertragen wird.

10. Leistungspanel (10) zum Erzeugen von thermischer und elektrischer Energie aus Sonnenstrahlung nach Anspruch 1, ferner umfassend:
ein transparentes Panel (22), das in direktem Kontakt mit den Seitenwänden des synthetischen, geformten Gehäuses positioniert ist und in Abstand oberhalb des photovoltaischen Panels (58) angeordnet ist, wobei das transparente Panel (22) so wirkt, dass es innerhalb des Gehäuses (12) enthaltene thermische Energie isoliert.

11. Leistungspanel (10) zum Erzeugen von thermischer und elektrischer Energie aus Sonnenstrahlung nach Anspruch 10, ferner enthaltend einen ersten Energiesammlungsstreifen (94), der an einem ersten Ende des Arrays angeordnet ist, und einen zweiten Energiesammlungsstreifen (104), der an einem entgegengesetzten zweiten Ende des Arrays angeordnet ist, wobei der erste und der zweite Energiesammlungsstreifen (94, 104) unter Verwendung der ersten Schicht aus Klebstoff (88) mit der ersten Fläche (70) des Trägers verbunden ist.

12. Leistungspanel (10) zum Erzeugen von thermischer und elektrischer Energie aus Sonnenstrahlung nach Anspruch 11, ferner enthaltend eine zweite Schicht aus Klebstoff (110), die direkt auf die Solarzellen (62, 62', 62", 62"') aufgebracht ist, wobei der erste und der zweite Energiesammlungsstreifen (94, 104) frei von der zweiten Schicht aus Klebstoff (110) sind.

13. Leistungspanel (10) zum Erzeugen von thermischer und elektrischer Energie aus Sonnenstrahlung nach Anspruch 10, wobei die Solarzellen (62, 62', 62", 62"') mehrere Busschienen (64a, 64b, 64c) aufweisen, die jeweils ein flexibles Band (116, 118, 120) haben, das sich von den Busschienen (64a, 64b, 64c) weg erstreckt, um elektrisch an diejenigen der Solarzellen (62, 62', 62", 62"') anzuschließen, die sich in der Nähe befinden.

14. Leistungspanel (10) zum Erzeugen von thermischer und elektrischer Energie aus Sonnenstrahlung nach Anspruch 10, wobei das Gehäuse (12) mindestens eine Einlassöffnung (49) und mindestens eine Auslassöffnung (50) aufweist, die ausgebildet sind, einen Einlass und einen Auslass bereitzustellen, damit ein Fluid zwischen der Oberfläche (20) und der zweiten Fläche (72) des PV-Zellträgers (60) in das Gehäuse (12) eintritt und aus diesem austritt.

## Revendications

1. Panneau d'alimentation (10) permettant de générer une énergie thermique et électrique à partir d'un rayonnement solaire, ledit panneau d'alimentation (10) comprenant :
un panneau transparent (22) qui fait face à une source de rayonnement solaire ;
un panneau photovoltaïque (PV) (58) permettant de générer une puissance électrique, placé sur un côté opposé du panneau transparent (22) à partir de la source de rayonnement solaire, le panneau photovoltaïque (58) comportant :
un plateau de cellules PV (60) possédant une première face (70) orientée vers la source de rayonnement solaire ;
une première couche d'un adhésif (88) appliquée sur la première face (70) du plateau de cellules PV (60) ; et
de multiples cellules solaires (62, 62', 62", 62'") connectées de manière fixe à la première face du plateau de cellules PV (70) grâce à la première couche de l'adhésif (88),
**caractérisé en ce que** les cellules solaires (62, 62', 62", 62'") sont agencées en séries, dans des colonnes de cellules (68a, 68b, 68c, 68d) individuelles,
dans lequel le panneau d'alimentation (10) comporte en outre un boitier moulé synthétique (12) comprenant une surface supérieure de rayonnement solaire (20), une surface de base et des parois latérales, le plateau de cellules PV (60) étant positionné au contact du boîtier moulé synthétique (12) et espacé au-dessus de la surface supérieure (20), le plateau de cellules PV (60) ayant une seconde face (72) dirigée en opposition à la première face (70) au contact d'un fluide s'écoulant le long de la surface supérieure ; et
dans lequel au moins la seconde face (72) comporte une pluralité d'alvéoles (76) qui forment un motif de surfaces surélevées qui facilitent le développement d'un flux turbulent de fluide.

2. Panneau d'alimentation (10) permettant de générer une énergie thermique et électrique à partir d'un rayonnement solaire selon la revendication 1, comportant en outre une première bande de récupération d'énergie (94) connectée à proximité d'une première extrémité (78) du plateau de cellules PV (60), et des deuxième et troisième bandes de récupération d'énergie (104, 106) placées toutes les deux à proximité d'une seconde extrémité (84) du plateau de cellules PV (60), chacune des bandes de récupération d'énergie (94, 104, 106) étant placée à l'extérieur des colonnes de cellules (68a, 68b, 68c, 68d) et connectée de manière fixe au plateau de cellules PV (60) grâce à la première couche de l'adhésif (88).

3. Panneau d'alimentation (10) permettant de générer une énergie thermique et électrique à partir d'un rayonnement solaire selon la revendication 2, comprenant en outre des première et seconde plaques de barre omnibus (100, 102) fixées directement sur la première couche de l'adhésif (88) et possédant l'une des cellules solaires, séparée, fixée sur l'une des première et seconde plaques de barre omnibus (100, 102) en utilisant une seconde couche de l'adhésif (110) appliquée sur les deux plaques de barre omnibus (100, 102) .

4. Panneau d'alimentation (10) permettant de générer une énergie thermique et électrique à partir d'un rayonnement solaire selon la revendication 3, dans lequel les colonnes de cellules (68a, 68b, 68c, 68d) séparées comprennent des première, deuxième, troisième et quatrième colonnes de cellules, chacune ayant une extrémité de connexion positive et une extrémité de connexion négative, et dans lequel :
l'extrémité de connexion positive de la première colonne de cellules (68a) est connectée à la deuxième plaque de barre omnibus (102) et l'extrémité de connexion négative de la première colonne de cellules (68a) est connectée à la deuxième bande de récupération d'énergie (104) ; et
l'extrémité de connexion négative de la deuxième colonne de cellules (68b) est connectée à la première plaque de barre omnibus (100) et l'extrémité de connexion positive de la deuxième colonne de cellules (68b) est connectée à la troisième bande de récupération d'énergie (106).

5. Panneau d'alimentation (10) permettant de générer une énergie thermique et électrique à partir d'un rayonnement solaire selon la revendication 4, dans lequel :
l'extrémité de connexion positive de la troisième colonne de cellules (68c) est connectée à la première bande de récupération d'énergie (94) et l'extrémité de connexion négative de la troisième colonne de cellules (68c) est connectée à la troisième bande de récupération d'énergie (106) ; et
l'extrémité de connexion négative de la quatrième colonne de cellules (68d) est connectée à la première bande de récupération d'énergie (94) et l'extrémité de connexion positive de la quatrième colonne de cellules (68d) est connectée à la deuxième bande de récupération d'énergie (104).

6. Panneau d'alimentation (10) permettant de générer une énergie thermique et électrique à partir d'un rayonnement solaire selon la revendication 3, dans lequel la seconde couche de l'adhésif (110) est appliquée sur la première et la seconde plaques de barre omnibus (100, 102), sauf sur une partie non couverte de la première plaque de barre omnibus (90) et une partie non couverte (92) de la seconde plaque de barre omnibus, les première et seconde parties non couvertes de plaque de barre omnibus étant placées à proximité de la première bande de récupération d'énergie (94).

7. Panneau d'alimentation (10) permettant de générer une énergie thermique et électrique à partir d'un rayonnement solaire selon la revendication 3, comportant en outre :
des premiers nodules (80) qui s'étendent en s'éloignant de la première face (70) placée à proximité de la première extrémité (78) du plateau de cellules PV (60) ; et
de multiples ouvertures d'alignement (96, 96') créées dans chacune de la première bande de récupération d'énergie (94) et des première et deuxième plaques de barre omnibus (100, 102), les premiers nodules (80) étant reçus séparément dans certaines, séparées, des ouvertures d'alignement (96, 96') afin de fixer la position de la première bande de récupération d'énergie (94) et des première et seconde plaques de barre omnibus (100, 102).

8. Panneau d'alimentation (10) permettant de générer une énergie thermique et électrique à partir d'un rayonnement solaire selon la revendication 3, comportant en outre :
des seconds nodules (86) qui s'étendent en s'éloignant de la première face (70) placée à proximité de la seconde extrémité (84) du plateau de cellules PV (60) ; et
de multiples ouvertures d'alignement (96") créées dans chacune des deuxième et troisième bandes de récupération d'énergie (104, 106), les seconds nodules (86) étant reçus séparément dans certaines, séparées, des ouvertures d'alignement (96") afin de fixer la position des deuxième et troisième bandes de récupération d'énergie (104, 106).

9. Panneau d'alimentation (10) permettant de générer une énergie thermique et électrique à partir d'un rayonnement solaire selon la revendication 1 :
dans lequel le plateau de cellules PV (60) comporte une seconde face (72) dirigée en opposition à la première face (70) ; et
une partie thermique du rayonnement solaire est transférée à un fluide au contact direct de la seconde face (72) du plateau de cellules PV.

10. Panneau d'alimentation (10) permettant de générer une énergie thermique et électrique à partir d'un rayonnement solaire selon la revendication 1, comportant en outre :
un panneau transparent (22) placé au contact direct avec les parois latérales du boitier moulé synthétique et espacé au-dessus du panneau photovoltaïque (58), le panneau transparent (22) agissant pour isoler l'énergie thermique contenue dans le boitier (12).

11. Panneau d'alimentation (10) permettant de générer une énergie thermique et électrique à partir d'un rayonnement solaire selon la revendication 10, comportant en outre une première bande de récupération d'énergie (94) située à une première extrémité du générateur photovoltaïque et une seconde bande de récupération d'énergie (104) située à une seconde extrémité opposée du générateur photovoltaïque, les première et seconde bandes de récupération d'énergie (94, 104) étant connectées à la première face du plateau (70) grâce à la première couche de l'adhésif (88) .

12. Panneau d'alimentation (10) permettant de générer une énergie thermique et électrique à partir d'un rayonnement solaire selon la revendication 11, comportant en outre une seconde couche de l'adhésif (110) appliquée directement sur les cellules solaires (62, 62', 62", 62'"), les première et seconde bandes de récupération d'énergie (94, 104) étant exemptes de la seconde couche de l'adhésif (110).

13. Panneau d'alimentation (10) permettant de générer une énergie thermique et électrique à partir d'un rayonnement solaire selon la revendication 10, dans lequel les cellules solaires (62, 62', 62", 62'") possèdent de multiples barres omnibus (64a, 64b, 64c), chacune ayant un ruban souple (116, 118, 120) qui s'étend en s'éloignant des barres omnibus (64a, 64b, 64c) afin de connecter électriquement les cellules proches parmi les cellules solaires (62, 62', 62", 62'").

14. Panneau photovoltaïque (10) permettant de générer une énergie thermique et électrique à partir d'un rayonnement solaire selon la revendication 10, dans lequel le boitier (12) comporte au moins un port d'entrée (49) et au moins un port de sortie (50) configurés pour fournir une entrée et une sortie pour qu'un fluide pénètre dans et sorte du boitier (12) entre la surface supérieure (20) et la seconde face (72) du plateau de cellules PV (60).
